# EUROPÄISCHE PATENTSCHRIFT

(11) **EP 0 830 054 B1**
(45) Veröffentlichungstag und Bekanntmachung des Hinweises auf die Patenterteilung: **30.01.2008**
(21) Anmeldenummer: 97115090.9
(22) Anmeldetag: 01.09.1997
(51) Int. Cl.: H05K 3/18

(54) **Verfahren zur Herstellung von starren und flexiblen Schaltungen**
Process for manufacturing rigid and flexible circuits
Procédé de fabrication de circuits rigides et flexibles

(30) Priorität: 12.09.1996 DE 19637018
(43) Veröffentlichungstag der Anmeldung: 18.03.1998
(73) Patentinhaber: H.C. Starck GmbH, 38642 Goslar (DE)
(72) Erfinder: Wolf, Gerhard-Dieter, Dr., 53332 Bornheim/Hemmerich (DE); Jonas, Friedrich, Dr., 52066 Aachen (DE)
(74) Vertreter: Clauswitz, Kai-Uwe Wolfram

(56) Entgegenhaltungen:
- EP-A- 0 413 109
- EP-A- 0 417 750
- EP-A- 0 686 662
- US-A- 5 262 041
- US-A- 5 403 467

## Beschreibung

Gegenstand der Erfindung ist ein Verfahren zur Herstellung von starren oder flexiblen elektrisch leitenden Leiterbahnen/Schaltungen oder auch von 3-D Molded Interconnection Devices unter der Mitverwendung eines leitenden Polymeren.

Die Herstellung von starren und flexiblen elektronischen Leiterbahnen/Schaltungen nach verschiedenen substraktiven, additiven und semiadditiven Verfahren auf starren und flexiblen Substraten ist allgemein bekannt und gehört seit vielen Jahren in verschiedenen Ausführungen zum Stand der Technik (Günther Herrmann, Handbuch der Leiterplattentechnik, Eugen G. Leuze Verlag, 1982, D-88348 Saulgau).

Seit einiger Zeit spielen leitende Polymere bei der Herstellung von Leiterplatten eine zunehmende Rolle. So wird in DE-OS 3 806 884 die Verwendung von leitenden Polymeren, insbesondere von Polypyrrol, zur direkten galvanischen Bohrlochmetallisierung von Leiterplatten und auch von flexiblen Schaltungen beschrieben. In US 5 403 467 wird speziell der Einsatz von Polythiophenen für denselben Zweck, nämlich für die direkte galvanische Leiterplattendurchkontaktierung beansprucht. In EP 0 413 109 wird Polyanilin als leitendes Polymer für den vorherig genannten Zweck eingesetzt.

Auch zur Herstellung von Leiterbahnen ist die Verwendung von leitenden Polymeren vorgeschlagen worden. In EP 615 256 ist ein Verfahren unter Einsatz von Poly-3,4-ethylendioxythiophen zur Herstellung von Leiterbahnen beschrieben. Bei diesem Verfahren wird das leitende Polymer in Form des gewünschten Leiterbahnenbildes aufgebracht bzw. strukturiert Dieses Verfahren hat den Nachteil, daß nach der Strukturierung der leitfähigen Schicht lediglich einzelne, untereinander nicht verbundene leitfähige Leiterbahnen auf dem Substrat vorliegen, die zur galvanischen Metallisierung dementsprechend einzeln kontaktiert werden müssen.

Gegenstand der Erfindung ist nun ein Verfahren zur Herstellung von starren und flexiblen elektronischen Schaltungen und von 3-D Molded Interconnection Devices, das diesen Nachteil der Kontaktierung der einzelnen Leiterbahnen verleidet.

Überraschenderweise gelingt in sehr einfacher Weise der Aufbau von Leiterbahnstrukturen mit hoher Gleichmäßigkeit und befriedigender Metallisierungsgeschwindikeit und Kontaktierung an nur noch einer Stelle der Schaltung, wenn die Herstellung der Schaltungen aus elektrisch leitenden Leiterbahnen nach dem erfindungsgemäßen Verfahren durchgeführt wird.

Das erfindungsgemäße Verfahren zur Herstellung von starren oder flexiblen Schaltungen aus während der Herstellung elektrisch leitend zusammenhängenden Leiterbahnen auf nicht leitenden Trägermaterialien ist durch die folgenden Verfahrensstufen gekennzeichnet:
a) Beschichten der Oberflächen der starren oder flexiblen Trägermaterialien einschließlich vorhandener Bohrlöcher mit einem leitenden Polymer ausgewählt aus der Gruppe Polypyrrol, Polythiophen oder deren Derivate, das Bindemittel enthalten kann,
b) Aufbringen eines Galvanoresists in Form des umgekehrten (negativen) Leiterbahnenbildes,
c) galvanische Metallisierung der von Galvanoresist freigehaltenen Oberfläche einschließlich vorhandener Bohrlöcher in Form des positiven Leiterbahnenbildes,
d) Entfernung des Galvanoresists und
e) Entfernung des leitenden Polymer von den nicht metallisierten Bereichen oder Überführung des leitenden Polymer in eine nicht leitfähige Form, durch Bestrahlung mit kurzwelligem Licht.

Das erfindungsgemäße Verfahren hat gegenüber dem Stand der Technik mit einzeln zu kontaktierenden, isolierten Leiterbahnen außerdem den Vorteil, daß durch die Kontaktierung der gesamten leitfähigen Fläche an den freiliegenden Leiterbahnen höhere Stromdichten und damit eine schnellere Metallisierung erreicht werden kann.

Mit Hilfe des erfindungsgemäßen Verfahrens können mechanisch stabile Leiterbahnen sowohl auf starren als auch auf flexiblen Trägermaterialien erzeugt werden.

Geeignete Trägermaterialien zur Herstellung flexibler Schaltungen sind Polymerfolien z.B. aus Polycarbonat, ABS, Polyvinylchlorid, Polyester, wie Polyethylenterephthalat, Polyethylennaphthalat, Polybutylenterephthalat, Polyimid, z.B. Kapton-Folien der Fa. DUPONT, und deren Blends.

Geeignete Trägermaterialien zur Herstellung starrer Schaltungen sind z.B. organische duromere Trägermaterialien auf Basis Phenolharz/Papier, glasfasergefüllter Epoxidharze, z.B. FR 3- und FR 4-Materialien (Handbuch der Leiterplattentechnik, loc. cit.), Epoxid-Isocyanuratharze, Polyimidharze bzw. thermoplastische Polymere, wie Polycarbonat, Polyester, ABS, Polystyrol, Polysulfone, deren Copolymere bzw. Blends.

Als elektrisch leitfähige Polymere für das erfindungsgemäße Verfahren sind geeignet: Gegebenenfalls substituierte Polypyrrole oder Polythiophene. Besonders bevorzugt sind gegebenenfalls substituierte Poly-3,4-ethylendioxythio-. phene, wie sie in EP 339 340 und EP 440 957 beschrieben sind.

Die Herstellung der leitfähigen Polymerschicht kann durch direkte Polymerisation der den leitfähigem Polymeren zugrundeliegenden Monomeren auf den Leiterplattensubstraten erfolgen. Entsprechende Verfahren sind bekannt und z.B. in EP 339 340 beschrieben. Weiterhin können zur Herstellung der leitfähigen Polymerschicht auch Lösungen oder Dispersionen der leitfähigen Polymere zur Beschichtung eingesetzt werden. Entsprechende Polymerlösungen bzw. Dispersionen sind z.B. in EP 440 957 beschrieben. Mischungen zur Erzielung von leitfähigen Beschichtungen mit niedrigem Oberflächenwiderstand <500 ohm/quadrat sind in EP 668 662 beschrieben. Das Aufbringen der leitfähigen Polymerschicht kann nach bekannten Verfahren z.B. durch Aufsprühen, Aufdrucken, Aufrakeln oder Aufgießen erfolgen. Das Aufbringen des leitfähigen Polymers erfolgt bevorzugt aus wäßriger Lösung. Weiterhin können der Lösung des leitfähigen Polymers wassermischbare Lösungsmittel, z.B. Alkohole, wie Methanol, Isopropanol, Ketone, wie Aceton, Methylethylketon, cycloaliphatische Amide, wie N-Methyl-pyrrolidon, N-Methylcaprolactam, aliphatische Amide, wie N,N-Dimethyl-acetamid, oder deren Gemische zugesetzt werden.

Den Lösungen der leitfähigen Polymere können Bindemittel zugesetzt werden. Geeignete Bindemittel sind z.B. aliphatische, aromatische oder aliphatisch/aromatische Polyimide, Polyhydantoine, Polyamidimide, Polyurethane, Polyacrylate, Epoxidharze, Polyvinylacetat, Polyvinylalkohol, Polyolefine, Polyester und deren Mischungen oder Copolymere (Einschichtaufbau). Es ist jedoch ebenfalls möglich, das Bindemittel in Form einer Lösung oder einer Dispersion als Primer und getrennt vom leitfähigen Polymer als eine erste Schicht aufzutragen und danach das leitfähige Polymer aufzubringen, wobei Trocknungsvorgänge eingeschoben werden. Auch in diesem Fall kann die Lösung des leitfähigen Polymer ein Bindemittel enthalten, das gleich oder verschieden vom Primer sein kann. Bei Verwendung von Gemischen der leitfähigen Polymere mit den Bindemitteln werden bevorzugt wäßrige Lösungen oder Dispersionen verwendet. Bei der Durchführung des erfindungsgemäßen Verfahrens mit einem solchen 2-Schichtaufbau kann der Primer auch aus organischer Lösung aufgebracht werden. Geeignete Lösungsmittel sind z.B. Alkohole, wie Methanol, Isopropanol, Glykol, Glyzerin, Ketone, wie Aceton, Methylethylketon, aliphatische oder cycloaliphatische Kohlenwasserstoffe, wie Hexan, Cyclohexan, aromatische Kohlenwasserstoffe, wie Toluol, Xylol, cycloaliphatische Amide, wie N-Methylpyrrolidon, N-Methylcaprolactam, aliphatische Amide wie N,N-Dimethylacetamid. Ferner kommen die speziell in der Druck- bzw. Lackiertechnik bekannten Substanzen in Betracht, wie Ester, beispielsweise Essigsäurebutylester, Phthalsäuredioctylester, Glykolsäurebutylester; Glykolether, beispielsweise Ethylenglykolmonomethylether, Diglyme, Propylenglykolmonomethylether; Ester von Glykolethern, beispielsweise Ethylenglykolacetat, Propylenglykolmonomethyletheracetat; Diacetonalkohol. Selbstverständlich können auch Gemische dieser Lösungsmittel und ihre Verschnitte mit anderen Lösungsmittels eingesetzt werden.

Den Lösungen der leitfähigen Polymere und/oder dem Primer können weiterhin organische oder anorganische Füllstoffe zugesetzt werden, die zu einer besseren Haftung der anschließend galvanisch aufgebrachten Metallschicht führen. Geeignete Füllstoffe sind z.B. Titandioxid, Siliziumdioxid, disperse Kieselsäuren, Tonmineralien, Ruße, Aerosile, Talkum, Eisenoxide, Kieselgur, Schwerspat, Kaoline, Quarzmehl, Zinksulfite, Chromgelb, Bronzen, organische Pigmente und Kreide. Bezogen auf die Summe aus leitfähigem Polymer und gegebenenfalls Bindemittel werden 0 bis 100 Gew.-% Füllstoff, bevorzugt 5 bis 50 Gew.-% Füllstoff, zugesetzt.

Die Dicke der Kombination aus Primerschicht und leitfähiger Polymerschicht (2-Schichtaufbau) bzw. der Kombination aus leitfähiger Polymerschicht, die gegebenenfalls ein Bindemittel enthält (Einschichtaufbau), liegt zwischen 0,05 und 100 µm, bevorzugt 0,5 und 20 µm.

An die Beschichtung der Trägersubstrate mit dem leitfähigen Polymeren schließt sich eine Trocknung der Polymerschicht und gegebenenfalls eine Temperung an. Die Trocknung und Temperung erfolgt abhängig von den verwendeten Lösungsmitteln und Bindern. Die Temperatur liegt üblicherweise zwischen Raumtemperatur und 300°C. Die Dauer liegt üblicherweise zwischen einigen Sekunden und mehreren Minuten für den Trockenschritt. Die Temperung kann bis zu einigen Stunden in Anspruch nehmen.

An die Beschichtung der Trägersubstrate mit der leitfähigen Polymerschicht schließt sich das Aufbringen des Galvanoresists (Fotoresists) an. Der Galvanoresist kann direkt strukturiert z.B. mit Siebdruckverfahren oder Gravuroffset aufgebracht werden. Es besteht aber auch die Möglichkeit, einen Galvanoresist vollflächig aufzubringen und nach üblichen Verfahren durch Belichten durch eine Maske und anschließende Entwicklung (fotolitografische Strukturierung) oder durch Laserablation (partielles bzw. stufenweises Ablatieren ohne Abtragung der darunterliegenden Schicht des leitenden Polymeren) zu strukturieren. Entsprechende Verfahren sind bekannt und z.B. in Handbuch der Leiterplattentechnik, loc. cit beschrieben. Es können auch Trockenresistfolien verwendet werden. In bevorzugter Weise wird ein Flüssigresist eingesetzt. Die Dicke des Galvanoresists liegt üblicherweise zwischen 5 µm und 100 µm.

An die Strukturierung des Galvanoresists schließt sich die galvanische Abscheidung der Metallschicht an. Die Galvanisierung erfolgt in handelsüblichen Metallisierungsbädern, wobei die leitfähige Polymerschicht als Kathode geschaltet wird. Metalle die abgeschieden werden können sind z B. Kupfer, Nickel, Gold, Silber, Palladium, Zinn, bzw. deren Legierungen. Ein geeignetes Kupferbad ist z.B. das Kupferbad Cuprostar LP 1 der Fa. Blasberg Oberflächentechnik, Solingen. Die Abscheidung erfolgt bei Stromstärken im Bereich von 0,1 bis 4 A/dm². Bevorzugt wird mit niedrigen Stromstärken begonnen, die bei der Galvanisierung langsam gesteigert werden. Die abgeschiedene Metallschicht beträgt zwischen 0,1 und 140 µm, bevorzugt 1µm und 50 µm.

Nach dem Abscheiden der Metallschicht wird der Galvanoresist und gegebenenfalls in einem Schritt die leitfähige Polymerschicht an den nichtmetallisierten Stellen entfernt bzw. die leitfahige Polymerschicht in einen nichtleitfähigen Zustand übergeführt. Die Entfernung ist beispielsweise durch Ablösen mit einem Lösungsmittel möglich; geeignet sind die Lösungsmittel, mit denen das Galvanoresist bzw. das elektrisch leitfähige Polymer in Lösung aufgebracht worden waren. Erfolgt das Entfernen des Galvanoresists und des Leitfähigen Polymers nacheinander,
- so kann das leitfähige Polymer durch Behandlung mit gasförmigen oder gelösten Oxidationsmitteln, wie Ozon, Kaliumpermanganat, Wasserstoffperoxid entfernt werden.

Die Umwandlung der leitfähigen Polymerschicht in die nichtleitfähige, isolierende Form kann durch Bestrahlung mit Kurzwelligem Licht, bevorzugt Kurzwelligem Ultraviolett < 300 µm Wellenlänge erfolgen.

### Beispiel

Auf eine 10 x 10 cm² große Platte aus Polyamid mit einem Glasfaseranteil von 30 Gew.-% wurde eine Lösung aus 10,0 g Poly-3,4-ethylendioxythlophen/Polystyrolsulfonatlösung in Wasser mit einem Feststoffgehalt von 1,3 Gew.-%, 0,15 g 3-Glycidoxypropyltrimethoxysilan, 2,0 g Sorbitlösung, 30 gew.-%ig in Wasser, 1,0 g N-Methylpyrrolidon und 6,0 g Isopropanol mit einer Lackschleuder bei 600 U/min aufgeschleudert und an der Luft getrocknet. Anschließend wurde die Platte 30 Minuten bei 150°C getempert. Auf diese Platte wurde der Galvanoresistlack Wepelan-Abdecklack SD 2154 E (Handelsprodukt der Lackwerke Peters, Kempen, BRD) in Form eines negativen Leiterbahnbildes per Siebdruck aufgebracht. Die Lackschicht wurde 30 Minuten bei 120°C getrocknet. Anschließend wurden die gegenüberliegenden freiliegenden Kanten des flächig aufgebrachten leitfähigen Polymeren kontaktiert, und in einem Kupferbad (Cuprostar LP1 der Fa. Blasberg Oberflächentechnik) wurde auf den freiliegenden Bereichen Kupfer galvanisch abgeschieden.

Es wurde 3 Stunden bei 1,5 A/dm² galvanisiert. Nach Spülen mit Wasser und Trocknen wurde der Galvanoresist mit Methylenchlorid abgelöst. Man erhielt das gewünschte Kupferleiterbahnbild auf der leitfähigen Polymerschicht. Die leitfähige Polymerschicht wurde durch 10minütiges Tauchen in eine Lösung aus 70 g/l Kaliumpermanganat in Wasser zerstört.

### Beispiel 2

Auf eine 10 x 10 cm² große Platte aus Polyamid mit einem Glasfaseranteil von 30 Gew.-% wurde als Primer eine Füllstoff enthaltende Primerzubereitung, bestehend aus 652 Gew.-Teilen einer 40 %igen wäßrigen Dispersion eines Polyurethans aus linearen, leicht verzweigten aliphatischen Ketten, mit -COO⁻ bzw. -SO₃⁻-Gruppen gemäß der DE-A 2 651 506 mit einer Teilchengröße von 50 bis 450 nm, 115 Gew.-Teilen TiO₂, 230 Gew.-Teilen Talkum in einer Trockenschichtdicke von 20 µm aufgesprüht. Anschließend wurde eine wäßrige Lösung aus 10,0 g Poly-3,4-ethylendioxythiophen/Polystyrolsulfonatlösung mit einem Feststoffgehalt von 1,3 Gew.-%, 0,15 g Glycidoxypropyltrimethoxysilan, 2,0 g Sorbitlösung, 30 gew.-%ig in Wasser, 2,0 g N-Methyl-pyrrolidon und 6,0 g Isopropanol mit einer Lackschleuder bei 600 U/min aufgeschleudert und an Luft getrocknet. Anschließend wurde die Platte 30 Minuten bei 150°C getempert.

Auf diese Platte wurde der Galvanoresistlack Wepelan-Abdecklack SD 2154E (Handelsprodukt der Lackwerke Peters, Kempen, BRD) in Form eines negativen Leiterbahnbildes per Siebdruck aufgebracht. Die Lackschicht wurde 30 Minuten bei 120°C getrocknet. Anschließend wurden die gegenüberliegenden freiliegenden Kanten des flächig aufgebrachten leitfähigen Polymeren kontaktiert und in einem Kupferbad (Cuprostar LP1 der Fa. Blasberg Oberflächentechnik) auf den freiliegenden Bereichen Kupfer galvanisch abgeschieden.

Es wurde 3 Stunden bei 1,5 A/dm² galvanisiert. Nach Spülen mit Wasser und Trocknen wurde der Galvanoresist mit Methylenchlorid abgelöst. Man erhielt das gewünschte Kupferleiterbahnbild auf der leitfähigen Polymerschicht. Die leitfähige Polymerschicht wurde durch 10minütiges Tauchen in eine Lösung aus 70 g/l Kaliumpermanganat in Wasser zerstört. Die Kupferbahnen wiesen eine Haftung. von 0,0254 N/m (20 N/inch)auf.

## Patentansprüche

1. Verfahren zur Herstellung von starren oder flexiblen Schaltungen aus während der Herstellung elektrisch leitend zusammenhängenden Leiterbahnen auf nichtleitenden Trägermaterialien, **gekennzeichnet durch** die Verfahrensstufen
a) Beschichten der Oberflächen der Trägermaterialien einschließlich vorhandener Bohrlöcher mit einem leitenden Polymer ausgewählt aus der Gruppe Polypyrrol, Polythiophen oder deren Derivate, das Bindemittel enthalten kann,
b) Aufbringen eines Galvanoresists in Form des negativen Leiterbahnenbildes,
c) galvanische Metallisierung der von Galvanoresist freigehaltenen Oberfläche einschließlich vorhandener Bohrlöcher in Form des positiven Leiterbahnenbildes,
d) Entfernung des Galvanoresists und
e) Entfernung des leitenden Polymer von den nicht metallisierten Bereichen oder Überführung des leitenden Polymer in eine nicht leitfähige Form, **durch** Bestrahlung mit kurzwelligem Licht.

2. Verfahren nach Anspruch 1, **dadurch gekennzeichnet, daß** als leitendes Polymer 3,4-Polyethylendioxythiophen eingesetzt wird.

3. Verfahren nach Ansprüchen 1 bis 2, **dadurch gekennzeichnet, daß** die ganzflächig aufgebrachte Schicht des leitenden Polymeren einen Oberflächenwiderstand <500 ohm/quadrat aufweist.

4. Verfahren nach Ansprüchen 1 bis 3, **dadurch gekennzeichnet, daß** vor dem leitenden Polymer ein Primer auf das Trägermaterial aufgebracht wird.

5. Verfahren nach Ansprüchen 1 bis 4, **dadurch gekennzeichnet, daß** der Galvanoresist flüssig oder fest aufgebracht wird und danach fotolithografrisch strukturiert wird.

6. Verfahren nach Ansprüchen 1 bis 5, **dadurch gekennzeichnet, daß** die Metallisierung in einem galvanischen Kupferbad erfolgt.

7. Verfahren nach Ansprüchen 1 bis 6, **dadurch gekennzeichnet, daß** die Primerschicht Füllstoffe enthält.

8. Verfahren nach Ansprüchen 1 bis 7, **dadurch gekennzeichnet, daß** die Schicht des leitfähigen Polymer Füllstoffe enthält.

## Claims

1. Process for producing rigid or flexible circuits from conductor tracks, electrically interconnected during the production step, on non-conductive support materials, **characterized by** the process stages of
a) coating the surfaces of the support materials including existing drill holes with a conductive polymer selected from the group consisting of polypyrrole, polythiophene and derivatives thereof, which may contain binders,
b) applying an electroplating resist in the form of the negative image of the conductor tracks,
c) metallizing by electroplating the surface kept free by the electroplating resist, including existing drill holes, in the form of the positive image of the conductor tracks,
d) removing the electroplating resist and
e) removing the conductive polymer from the non-metallized areas or converting the conductive polymer to a non-conductive form by irradiation with short wave light.

2. Process according to Claim 1, **characterized in that** the conductive polymer used is 3,4-polyethylenedioxythiophene.

3. Process according to Claims 1 and 2, **characterized in that** the layer of conductive polymer applied over the entire surface shows a surface resistivity of <500 ohm/square.

4. Process according to Claims 1 to 3, **characterized in that**, before the conductive polymer, a primer is applied to the support material.

5. Process according to Claims 1 to 4, **characterized in that** the electroplating resist is applied in liquid or solid form and is then photolithographically structured.

6. Process according to Claims 1 to 5, **characterized in that** the metallization is carried out in an electroplating copper bath.

7. Process according to Claims 1 to 6, **characterized in that** the primer layer contains fillers.

8. Process according to Claims 1 to 7, **characterized in that** the layer of conductive polymer contains fillers.

## Revendications

1. Procédé de fabrication de circuits rigides ou flexibles, à partir de pistes conductrices solidarisées par conduction électrique pendant la fabrication, sur des substrats non conducteurs, **caractérisé par** les étapes de procédé suivantes :
a) revêtement des surfaces des substrats, y compris les orifices de perçage présents, avec un polymère conducteur sélectionné dans le groupe des polypyrroles, des polythiophènes ou de leurs dérivés, pouvant contenir un liant,
b) application d'un galvanoresist sous la forme de l'image négative des pistes conductrices,
c) métallisation galvanique de la surface exempte du galvanoresist, y compris les orifices de perçage présents, sous la forme de l'image positive des pistes conductrices,
d) retrait du galvanoresist et
e) retrait du polymère conducteur des régions non métallisées ou bien transformation du polymère conducteur en une forme non conductrice, par une irradiation avec une lumière à ondes courtes.

2. Procédé selon la revendication 1, **caractérisé en ce que** du 3,4-polyéthylène-dioxythiophène est utilisé comme polymère conducteur.

3. Procédé selon les revendications 1 à 2, **caractérisé en ce que** la couche de polymère conducteur, appliquée sur l'ensemble de la surface, présente une résistance de surface < 500 ohm / carré.

4. Procédé selon les revendications 1 à 3, **caractérisé en ce qu'**une couche primaire est appliquée avant le polymère conducteur sur le substrat.

5. Procédé selon les revendications 1 à 4, **caractérisé en ce que** le galvanoresist est appliqué à l'état solide ou liquide, puis structuré par photolithographie.

6. Procédé selon les revendications 1 à 5, **caractérisé en ce que** la métallisation est effectuée dans un bain de cuivre galvanique.

7. Procédé selon les revendications 1 à 6, **caractérisé en ce que** la couche primaire contient des matières de remplissage.

8. Procédé selon les revendications 1 à 7, **caractérisé en ce que** la couche de polymère conducteur contient des matières de remplissage.
